# EUROPEAN PATENT SPECIFICATION

(11) **EP 0 364 416 B1**
(45) Date of publication and mention of the grant of the patent: **12.10.1994**
(21) Application number: 89850267.9
(22) Date of filing: 23.08.1989
(51) Int. Cl.: H05K 7/18

(54) **Printed circuit board for mounting in the back plane of a card frame**
Gedruckte Schaltung für die Montage in der Hinterebene eines Kartengestellrahmens
Circuit imprimé à monter dans le plan arrière d'un châssis pour plaques à circuit imprimé

(30) Priority: 12.10.1988 SE 8803634
(43) Date of publication of application: 18.04.1990
(73) Proprietor: TELEFONAKTIEBOLAGET L M ERICSSON, 126 25 Stockholm (SE)
(72) Inventor: Olsson, Torbjörn Rolf, S-146 00 Tullinge (SE); Kassman, Björn Ture, S-136 48 Haninge (SE); Nilsson, Per-Ove, S-124 45 Bandhagen (SE); Olsson, Karl-Gustaf, S-113 24 Stockholm (SE); Ernolf, Stig Carl-Oskar, S-191 50 Sollentuna (SE); Kjellsson, Rolf Ingvar Birger, S-126 41 Hägersten (SE); Widoff, Lars Herbert, S-652 21 Karlstad (SE)
(74) Representative: Lövgren, Tage

(56) References cited:
- US-A- 3 992 686
- US-A- 4 131 933
- US-A- 4 511 950

## Description

### TECHNICAL FIELD

The present invention relates to a magazine, comprising a card frame and a back plane including a printed circuit board, in which printed circuit cards can be inserted perpendicularly to said plane, said circuit board being provided with electrical contact devices, said circuit cards having electrical contact devices which correspond to the contact devices on the printed circuit board, and said printed circuit board forming an electrical connecting unit for the circuit cards located in the back plane of the magazine.

### BACKGROUND ART

Magazines intended for accomodating printed circuit cards included, for instance, in telephone exchange systems normally comprise a card frame which consists of two end plates, profiled sections which are screwed to respective end plates, and a back plate which is mounted in the back of the card frame and which functions to stiffen the actual card frame mechanically, and together with the profiled sections, to support a printed circuit board which constitutes the coupling between printed circuit cards inserted into the magazine at right angles to the printed circuit board. The printed circuit board and the printed circuit cards are provided with mutually cooperating devices, for connecting the card to the circuit board electrically.

Such magazines are for exemple known from US-A-4 131 933.

Because the printed circuit board is relatively thin and has practically no resistance to bending and torsion forces, the forces occuring when inserting a printed circuit card into the magazine and removing a card therefrom are taken up by the rear profiled sections of the magazine and the back plate thereof. In the case of large magazines, it is necessary to further stiffen the printed circuit board, with the aid of additional profiled sections located in the back plane of the card frame. Consequently, the mechanical construction of the magazine in its back plane often becomes complicated and bulky. Attachment of the printed circuit board is also complicated and the various working steps involved are time consuming. Furthermore, the requisite mechanical stiffening of the printed circuit board means renders part of the board surface unavailable for use, because of the presence of the necessary attachment devices.

US-A-3992686 discloses a backplane motherboard made of different layers as a sandwich element, at least two of these layers being of electrically conducting material forming a ground plane and a voltage plane respectively. Microstrip transmission lines are etched on the outside of the outer layers of the sandwich element. Plural female connectors are mounted on the inside of the motherboard in order to provide connections to components mounted on printed circuit cards inserted in the connectors. The purpose of this device is to provide a system for interconnecting a plurality of electronic devices and components, including power supply, and where several printed circuit cards can be mounted in a compact space. The problem with this motherboard is that it is not of a stiff self-supporting construction, that permits removal and reinsertion of the printed circuit cards without special means for additional mechanical stiffening of the motherboard.

US-A-4511950 discloses a backpanel provided with connectors into which printed circuit cards can be plugged. The backpanel can be in the form of a sandwich element, for the same purpose as with the motherboard indicated above. Thus, the problem with a backpanel not being of a self-supporting stiff element exist.

US-A-4131933 discloses a printed circuit board provided with electrical connectors and intended to be mounted in the back plane of a card frame. The board is attached to a board stiffener, i.e. a separate device distinguished from the board itself and provided with openings corresponding to the connectors on the board, the board being mounted in a recess in the board stiffener. Thus this solution is a complicated and bulky mechanical construction of the same kind as indicated above.

### DISCLOSURE OF INVENTION

Consequently, the object of the present invention is to avoid the drawbacks associated with known magazines, by configuring the back plane as a self-supporting structure, in the form of a torsionally rigid sandwich element. The sandwich element comprises a spacer element which is bonded to a bottom plate and also to the printed circuit board.

According to one preferred embodiment, the spacer element comprises a layer of a foam plastic, and the bottom plate is preferably manufactured from a material which has the same coefficient of linear expansion as the printed circuit board.

According to one preferred embodiment, the spacer element covers the whole of the rear side of the printed circuit board. The back plane is preferably provided along the edges thereof with fastener elements or through-passing holes for attachment of the plane to the card frame with the aid of screws or like fasteners.

A back plane configured in accordance with the invention provides several advantages. One advantage is that no separate mechanical constructions need be arranged in the back plane of the card frame for the purpose of taking up forces and for stiffening the magazine, since the forces which occur when inserting the printed circuit cards into the magazine and when removing said cards thereform are taken up by the back plane itself, which also serves to stiffen the card frame.

Another advantage is that because no separate devices are required for stiffening the back plane in the card frame, the whole of the surface of the printed circuit board is available for coaction with electrical contact devices. Thus the contact devices can be placed freely within the surface area provided and enables the use of different types of electrical contact devices.

Further advantages afforded by a magazine according to the claims will be apparent from the following description and the accompanying drawing.

### BRIEF DESCRIPTION OF DRAWING

Figure 1 illustrates schematically and in perspective a card frame and a back plane according to the invention, intended for forming a circuit card magazine.

Figure 2 is a side view of the inventive back plane.

### BEST MODE FOR CARRYING OUT THE INVENTION

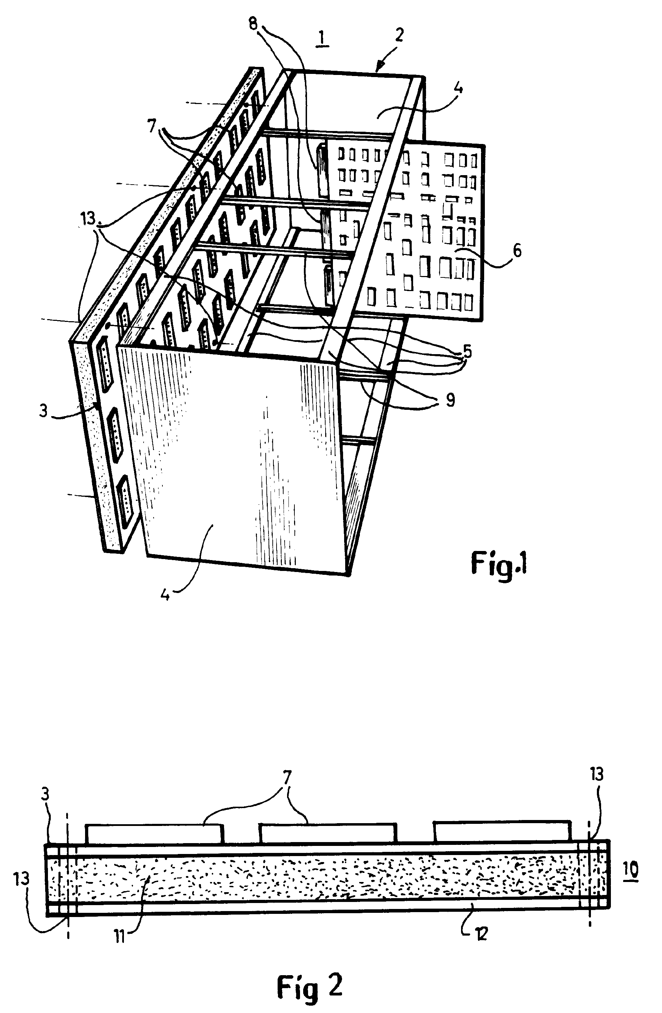

Figure 1 is a perspective view of a magazine 1 according to the invention which comprises a card frame 2 and a back plane, including a printed circuit board 3. The card frame 2 is of conventional construction, and consists of two end plates 4 and four profiled sections 5 which connect the end plates together and are fastened at respective corners, for instance by means of screws. The card frame 2 is normally made of aluminium. Instead of the conventional back plate, the back plane of the magazine 1, however, consists of a sandwich element, the nature of which will be described in more detail herebelow.

Printed circuit cards 6 can be inserted perpendicularly to the thus formed back plane of the magazine, i.e. perpendicularly to the printed circuit board 3. The board 3 constitutes an electrical connecting unit between the printed circuit cards 6 and is, to this end, provided with electrical contact devices 7, whereas the printed circuit cards are provided with electrical contact devices 8 corresponding to the contact devices of the printed circuit board, as shown schematically in Figure 1. The cards 6 are guided in the card frame 2 by means of guide rails 9, for instance plastic rails, which extend in the card frame 2 beneath the upper and lower profiled sections 5 respectively.

The back plane including the printed circuit board 3 will now be described with reference to Figure 2. The board is manufactured, e.g., of glass-fibre reinforced epoxy-resin and is provided with conductor paths, such as to enable the board to function as an electrical connecting unit for the printed circuit cards 6. As beforementioned, electrical contact devices 7 are mounted on the front face of the pc-board. In order to make the back plane a self-supporting unit, the rear side of the printed circuit board 3 is configured as a stiffening construction in the form of a sandwich element 10. According to one preferred embodiment, the sandwich element 10 comprises a spacer element 11 bonded adhesively to a bottom plate 12 and secured to the circuit board. The spacer element comprises a layer of foamed plastic, e.g. PVC, and the bottom plate 12 is manufactured from a material which has the same coefficient of linear expansion as the printed circuit board 3, normally a glass-fibre reinforced epoxy. The spacer element 11 is bonded adhesively to the printed circuit board 3, preferably subsequent to said board having been completed and tested and provided with electrical contact devices 7.

In order to enable the back plane to be mounted on the rear side of the card frame 2, the plane is provided along the edges thereof with through-passing holes 13, and the plane is screwed firmly to the rear profiled sections 5 of the card frame 2, or fastened in some other suitable manner. Alternatively, fasteners can be provided along the edges of the back plane and fastened to the profiled sections of the card frame.

Because the back plane is a self-supporting, stiffening structure, as described in the foregoing, no separate mechanical reinforcements are required in the back plane of the magazine, in order to stiffen the magazine and to support the circuit board. Furthermore, because the back plane is attached to the card frame solely along the edge surfaces of the plane, the whole of the surface of the printed circuit board is available for the provison of electrical contact devices, which can thus be placed freely within the available surface area.

It will be understood that the invention is not restricted to the described and illustrated embodiment, and that modifications can be made within the scope of the accompanying claims.

## Claims

1. A magazine (1), comprising a card frame (2) and a back plane including a printed circuit board (3), in which printed circuit cards (6) can be inserted perpendicularly to said plane, said circuit board (3) being provided with electrical contact devices (7), said circuit cards (6) having electrical contact devices (8) which correspond to the contact devices on the printed circuit board, and said printed circuit board forming an electrical connecting unit for the circuit cards located in the rear plane of the magazine, **characterized** in that the back plane consists of a sandwich element (10), comprising the printed circuit board (3), a spacer element (11) and a bottom plate (12), the spacer element (11) being bonded adhesively to the board (3) and to the bottom plate (12), so as to form a self-supporting and stiffening construction.

2. A magazine according to claim 1, **characterized** in that the spacer element (11) comprises a layer of a foamed plastic.

3. A magazine according to claim 1, **characterized** in that the bottom plate (12) is made of a material which has the same coefficient of linear expansion as the printed circuit board (3).

4. A magazine according to any one of claims 1-3, **characterized** in that the spacer element (11) covers the whole of the rear surface of the printed circuit board (3).

5. A magazine according to any one of claims 1-4, **characterized** in that the sandwich element (10) is provided along the edges thereof with fastener elements or through-passing holes (13) for attaching the element to the card frame (2) with the aid of screw fasteners or the like.

## Patentansprüche

1. Magazin (1), umfassend einen Kartengestellrahmen (2) und eine Hinterebene mit einer Leiterplatte (3), in die Schaltungsplatinen (6) senkrecht zu der Ebene eingefügt werden können, wobei die Leiterplatte (3) mit elektrischen Kontakteinrichtungen (7) versehen ist und die Schaltungsplatinen (6) elektrische Kontakteinrichtungen (8) aufweisen, die den Kontakteinrichtungen auf der Leiterplatte entsprechen, und wobei die Leiterplatte eine elektrische Verbindungseinheit für die in der Hinterebene des Magazins angeordneten Schaltungsplatinen bildet,
**dadurch** **gekennzeichnet,** **daß**
die Hinterebene aus einem Sandwich-Element (10) besteht, welches die Leiterplatte (3), ein Abstandselement (10) und eine Bodenplatte (12) umfaßt, wobei das Abstandselement (11) mit der Leiterplatte (3) und an die Bodenplatte (2) klebend verbunden ist, um so einen selbsttragenden und versteifenden Aufbau zu bilden.

2. Magazin nach Anspruch 1,
**dadurch** **gekennzeichnet**, **daß**
das Abstandselement (11) eine Schicht aus einem Schaumplastik umfaßt.

3. Magazin nach Anspruch 1,
**dadurch** **gekennzeichnet,** **daß**
die Bodenplatte (12) aus einem Material hergestellt ist, welches den gleichen linearen Ausdehnungskoeffizienten wie die Leiterplatte (3) aufweist.

4. Magazin nach einem der Ansprüche 1 - 3,
**dadurch** **gekennzeichnet**, **daß**
das Abstandselement (11) die gesamte hintere Oberfläche der Leiterplatte (3) bedeckt.

5. Magazin nach einem der Ansprüche 1 - 4,
**dadurch** **gekennzeichnet**, **daß**
das Sandwich-Element (10) entlang seiner Kanten mit Befestigungselementen oder Durchgangslöchern (13) zur Anbringung des Elements an dem Kartengestellrahmen (2) mittels Schrauben-Befestigungseinrichtungen oder dergleichen versehen ist.

## Revendications

1. Magasin (1), comportant un porte-cartes (2) et un panneau arrière de connexion comprenant une plaquette (3) à circuit imprimé, dans lequel des cartes (6) à circuits imprimés peuvent être insérées perpendiculairement audit panneau, ladite plaquette (3) à circuit étant pourvue de dispositifs (7) de contact électrique, lesdites cartes à circuits (6) ayant des dispositifs (8) de contact électrique qui correspondent aux dispositifs de contact sur la plaquette à circuit imprimé, et ladite plaquette à circuit imprimé formant une unité de connexion électrique pour les cartes à circuits placées dans le panneau arrière du magasin, caractérisé en ce que le panneau arrière de connexion est constitué d'un élément (10) en sandwich, comprenant la plaquette (3) à circuit imprimé, un élément d'entretoisement (11) et une plaque de fond (12), l'élément d'entretoisement (11) étant lié par un adhésif à la plaquette (3) et à la plaque de fond (12) afin de former une construction autoportante et raidissante.

2. Magasin selon la revendication 1, caractérisé en ce que l'élément d'entretoisement (11) comprend une couche de mousse de matière plastique.

3. Magasin selon la revendication 1, caractérisé en ce que la plaque de fond (12) est formée d'une matière ayant le même coefficient de dilatation linéaire que la plaquette (3) à circuit imprimé.

4. Magasin selon l'une quelconque des revendications 1 à 3, caractérisé en ce que l'élément d'entretoisement (11) recouvre la totalité de la surface arrière de la plaquette (3) à circuit imprimé.

5. Magasin selon l'une quelconque des revendications 1-4, caractérisé en ce que l'élément en sandwich (10) est pourvu, le long de ses bords, d'éléments de fixation ou de trous traversants (13) pour fixer l'élément au porte-cartes (2) à l'aide d'organes de fixation à vis ou analogues.
